(19) **Europäisches Patentamt**
**European Patent Office**
**Office européen des brevets**

(11) **EP 2 642 306 B1**

(12) **EUROPEAN PATENT SPECIFICATION**

(45) Date of publication and mention
of the grant of the patent:
**22.05.2019 Bulletin 2019/21**

(51) Int Cl.:
**G01R 31/12** *(2006.01)*      **H01B 13/00** *(2006.01)*
**G01R 31/02** *(2006.01)*

(21) Application number: **11838064.1**

(86) International application number:
**PCT/JP2011/075303**

(22) Date of filing: **02.11.2011**

(87) International publication number:
**WO 2012/060414 (10.05.2012 Gazette 2012/19)**

(54) **HIGH VOLTAGE TESTING DEVICE**

HOCHSPANNUNGSTESTVORRICHTUNG

DISPOSITIF DE TEST À HAUTE TENSION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **02.11.2010 JP 2010246474**

(43) Date of publication of application:
**25.09.2013 Bulletin 2013/39**

(73) Proprietor: **Yazaki Corporation
Minato-ku
Tokyo 108-8333 (JP)**

(72) Inventors:
• **OIWA, Kazuyuki
Shizuoka (JP)**

• **YAGI, Daisuke
Shizuoka (JP)**

(74) Representative: **Grünecker Patent- und
Rechtsanwälte
PartG mbB
Leopoldstraße 4
80802 München (DE)**

(56) References cited:
**JP-A- 1 191 073      JP-A- 9 292 435
JP-A- 11 281 685      JP-A- H01 191 073
JP-A- 2000 028 674    JP-A- 2000 028 674
JP-A- 2009 004 147    US-A- 4 647 844**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The present invention relates to a high voltage testing device which uses a coaxial cable as an object to be inspected and applies a high voltage between a center conductor (a core wire) and a shield conductor of the coaxial cable to carry out a test of an electric insulation state.

For instance, when an input of a radio device such as a radio or a television is connected to an antenna, a coaxial cable is ordinarily used. Such kind of coaxial cable is formed with a center conductor having a prescribed thickness and a shield conductor arranged in a tubular form so as to surround the periphery of the center conductor with a prescribed insulating material sandwiched between the shield conductor and the center conductor. When an input of a broadcasting radio receiver mounted on a vehicle is connected to an antenna, such a coaxial cable is also used.

As disclosed in patent literature 1, a capacitor may be sometimes inserted into a part of a center conductor of a coaxial cable.

On the other hand, when a user employs an electric wire such as this kind of coaxial cable for various uses, the user needs to carry out an electric inspection to ensure a safety or a quality of the electric wire. Specifically, the user recognizes that insulation is ensured between the center conductor and the shield conductor of the coaxial cable. Then, the user applies a DC high voltage (for instance, 1000 V) to a part between them to measure an insulation resistance or applies an alternating voltage (for instance, an amplitude is 1000 V) of a frequency (for instance, 50 Hz) the same as that of a commercial AC power to recognize that a problem does not arise in withstand voltage.

Further, for instance, patent literature 2 discloses an insulation monitor which monitors a deterioration of an electric insulator of an electric wire in a switchboard. Namely, a technique is disclosed that an electromagnetic wave radiated due to a partial discharge caused by the deterioration of the insulation is detected and monitored by using an antenna arranged in the switchboard. A further cable testing instrument is disclosed in patent literature 3.

Patent Literature 1: JP-A-2001-202836
Patent Literature 2: JP-A-2005-265684
Patent Literature 3: JP H01 191073 A

For instance, when an insulation resistance of an ordinary coaxial cable is measured, two electrodes of an insulation resistance tester are connected to a center conductor and a shield conductor of the coaxial cable as an object to be inspected and a prescribed voltage is applied to the electrodes so that a test may be simply carried out.

However, as described above, when the coaxial cable having the capacitor inserted into a part of the center conductor is tested, various problems may possibly arise. Namely, since one end and the other end of the coaxial cable in the longitudinal direction thereof cable are separated from each other in a direct current by the capacitor, when the two electrodes of the insulation resistance tester are merely connected to the center conductor and the shield conductor in the one end of the coaxial cable, only a range from the one end of the coaxial cable to one end of the capacitor can be tested. Accordingly, after the test of the one end side of the coaxial cable is finished, the two electrodes of the insulation resistance tester are reconnected to the center conductor and the shield conductor in the other end of the same coaxial cable to carry out a test again.

Further, when an insulation resistance test or a withstand voltage test is carried out, a high voltage of about 1000 V is ordinarily applied. A withstand voltage of the capacitor itself built in the coaxial cable is ordinarily about 50 V at the most. Accordingly, when an operator makes an erroneous connecting operation during the test or when there is a problem in an insulation property of the coaxial cable itself, the capacitor of the coaxial cable may be possibly broken by applying an excessively high voltage.

The present invention is devised by considering the above-described circumstances, and it is an object of the present invention to provide a high voltage testing device which can carry out a test of an entire part of a cable by a simple operation without breaking a capacitor even when a coaxial cable having a capacitor built therein is tested.

This is achieved by the features of the independent claims.

(1) In a high voltage testing device for inspecting a coaxial cable including a central conductor and a shield conductor arranged so as to surround a periphery of the central conductor with a prescribed insulating material sandwiched between the central conductor and the shield conductor and applies a high voltage between the central conductor and the shield conductor of the coaxial cable to carry out a test of an electric insulation state, the high voltage testing device includes: a cable connecting part that respectively connects two electrodes of an output of a tester which outputs a high voltage to the central conductor and the shield conductor of the coaxial cable as the object to be inspected, and the cable connecting part includes a core wire short-circuiting part which electrically short-circuits between one end and the other end in the longitudinal direction of the central conductor of the coaxial cable and a shield wire shirt-circuiting part which electrically short-circuits between one end and the other end in the longitudinal direction of the shield conductor of the coaxial cable.

(2) A high voltage testing device according to the above-described (1) further includes a time constant circuit that is connected between the output of the tester and an input of the cable connecting part and that has at least one resistor and at least one capacitor.

(3) In a high voltage testing device according to the above- described (2), the time constant circuit has a surge removing circuit which absorbs an abnormal high voltage.

(4) In a high voltage testing device according to the above-described (1), the cable connecting part includes two or more coaxial connectors which are respectively connected to two connectors provided in one end side and the other end side in the longitudinal direction of the coaxial cable as the object to be inspected.

According to the high voltage testing device having the structure of the above-described (1), even when a capacitor is provided in the coaxial cable as the object to be inspected, the high voltage can be prevented from being applied between terminals of the capacitor. Further, the voltage for a test is applied to both the ends of the coaxial cable at the same time through the core wire short-circuiting part. Accordingly, an entire part of the coaxial cable can be tested by the test of one time without carrying out the tests individually two times. Even when the length of the coaxial cable as the object to be inspected is relatively large, the voltage applied between the terminals of the capacitor can be restrained from increasing.

According to the high voltage testing device having the structure of the above-described (2), a change speed of the high voltage applied to the coaxial cable as the object to be inspected from the tester can be moderated. Thus, an influence of an inductor component in the coaxial cable is mitigated. Accordingly, even when the length of the coaxial cable as the object to be inspected is relatively large, the voltage applied between the terminals of the capacitor can be restrained from increasing.

According to the high voltage testing device having the structure of the above-described (3), when an abnormal high voltage is temporarily applied due to any cause, the surge removing circuit absorbs the abnormal high voltage. Accordingly, the voltage applied between the terminals of the capacitor can be restrained from increasing.

According to the high voltage testing device having the structure of the above-described (4), when both the ends of the coaxial cable as the object to be inspected are merely connected to the two coaxial connectors of the cable connecting part, the test can be safely carried out. Namely, an excessively high voltage can be prevented from being applied to the capacitor in the coaxial cable by a mal-operation.

The present invention is briefly explained as described above. Further, when mode for carrying out the invention described below is read by referring to the attached drawings, a detail of the present invention will be more clarified.

Fig. 1 is a connection diagram showing a connection state when a wire harness for an antenna is tested by using a high voltage testing device of an exemplary embodiment.

Fig. 2 is an electric circuit diagram showing an equivalent circuit of an electric circuit shown in Fig. 1.

Fig. 3 is a front view of a structural example of the wire harness for the antenna as an object to be inspected.

Fig. 4 is a schematic view showing the connection states of circuit elements of parts which respectively give an influence when a voltage for a test is applied to the wire harness for the antenna as shown in Fig. 1 and Fig. 3.

Fig. 5 is an electric circuit diagram showing an equivalent circuit of the wire harness for the antenna immediately after a DC voltage for the test is applied.

Fig. 6 is an electric circuit diagram showing the equivalent circuit of the wire harness for the antenna after the DC voltage for the test is applied, and then, a sufficient time elapses.

Fig. 7 is a wave form diagram showing a wave form of a voltage when a jig for a high voltage test has no time constant circuit.

Fig. 8 is a wave form diagram showing a wave form of a voltage when the jig for the high voltage test has the time constant circuit.

Fig. 9 is a wave form diagram showing an example of a wave form of a voltage appearing between terminals of a capacitor in the wire harness for the antenna in an actual test state.

Fig. 10 is a connection diagram showing a connection state when the wire harness for the antenna is tested by using a high voltage testing device of a modified example.

Now, a specific exemplary embodiment of a high voltage testing device of the present invention will be described below by referring to the drawings.

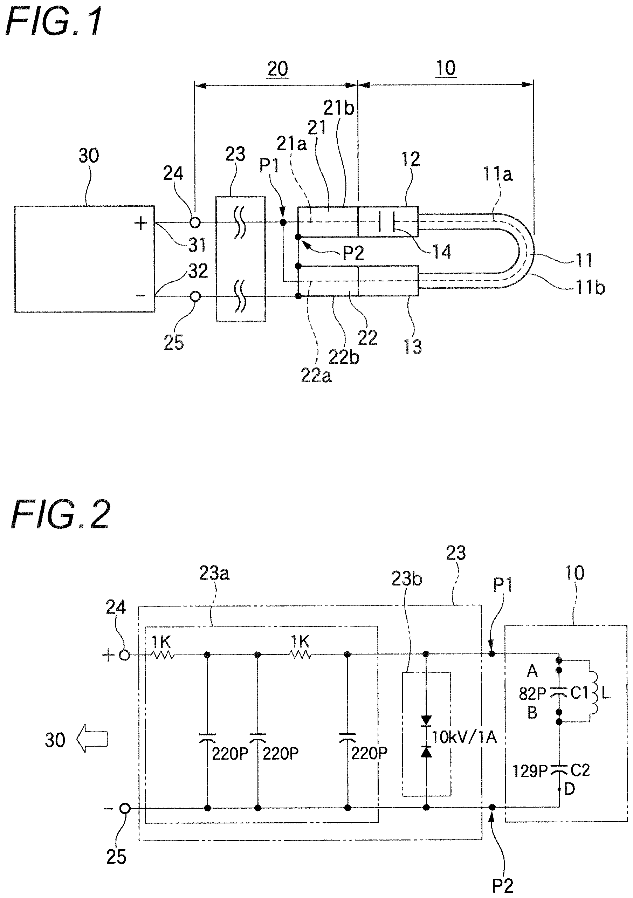

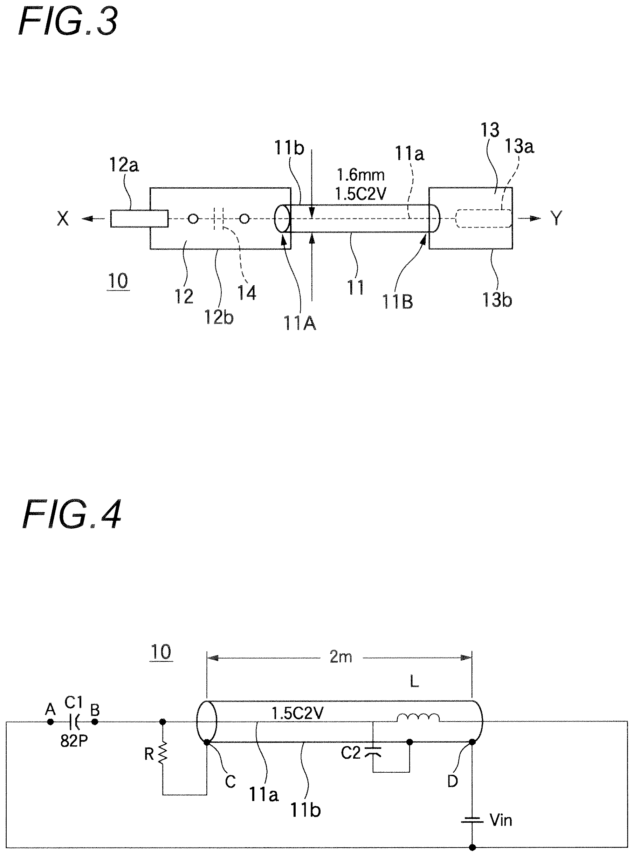

Fig. 1 shows a specific example of a connection state when a wire harness for an antenna is tested by using a high voltage testing device of an exemplary embodiment. Further, in the present exemplary embodiment, as a representative example, a wire harness 10 for an antenna as shown in Fig. 3 is supposed to be used as an object to be inspected.

The wire harness 10 for an antenna is used, as shown in Fig. 3, to connect a prescribed radio unit (an input of a broadcasting radio receiver mounted on a vehicle) X to an antenna amplifier (an amplifier which amplifies a high frequency signal from an antenna mounted on a vehicle) Y. Further, as shown in Fig. 3, the wire harness 10 for the antenna includes a coaxial cable (1.5C2V) 11 having a length to some degree (for instance, 1.6 m) and harness side connectors 12 and 13 respectively connected to one end 11A and the other end 11B of the coaxial cable. Further, inside the harness side connector 12, a capacitor 14 is built.

Specifically, the harness side connector 12 is a JASO plug adapted to a standard of Japanese Automotive Standards Organization (JASO). Further, the harness side connector 13 is a high frequency connector (HFC) for the coaxial cable.

The coaxial cable 11 has a core wire 11a which is an electrical conductor having a prescribed thickness in its central part. An outer periphery of the core wire 11a is covered with a prescribed electrically insulating material. Further, in an outer side of the electrically insulating material, a shield conductor 11b formed in a cylindrical configuration is arranged so as to surround the core wire 11a. Namely, the core wire 11a and the shield conductor 11b are coaxially arranged and the core wire and the shield conductor are insulated from each other by the electrically insulating material. Further, an outer side of the shield conductor 11b is covered with a suitable sheath (an insulator).

The capacitor 14 provided in the harness side connector 12 serves to match the coaxial cable with a signal source of an antenna system (for instance, in Fig. 3, the radio unit X or the antenna amplifier Y corresponds to the antenna system) to which the coaxial cable 11 is connected, and functions as a matching correction capacitor. Namely, as shown in Fig. 3, one end of the capacitor 14 is connected to the core wire 11a in the one end 11A of the coaxial cable 11, and the other end of the capacitor 14 is connected to a central electrode 12a of the harness side connector 12. As in this structure, the wire harness 10 for the antenna has a function for matching the coaxial cable with the signal source of the antenna system.

Further, an electrode 12b of an outer periphery of the harness side connector 12 is connected to the shield conductor 11b in the one end 11A of the coaxial cable 11. A central electrode 13a of the harness side connector 13 is connected to the core wire 11a in the other end 11B of the coaxial cable 11. An electrode 13b of an outer periphery is connected to the shield conductor 11b in the other end 11B of the coaxial cable 11.

When the wire harness 10 for the antenna shown in Fig. 3 is tested as an object to be inspected, the wire harness for the antenna is connected to a jig for a high voltage test (a high voltage testing device) 20 as shown in Fig. 1. Namely, since the coaxial cable 11 has a flexibility, the wire harness 10 for the antenna is bent in the form of U to mechanically and electrically connect the harness side connector (a plug) 12 of one end side thereof to a tester side connector (a jack) and, to mechanically and electrically connect the harness side connector (a female) 13 of the other end side to a tester side connector (a male) 22.

The jig for the high voltage test 20 shown in Fig. 1 includes the tester side connectors 21 and 22 and a jig circuit 23. The tester side connector 21 and the tester side connector 22 are arranged at positions close to each other. Further, a central electrode 21a of the tester side connector 21 is connected to a central electrode 22a of the tester side connector 22 at a core wire short-circuiting part P1. An outer periphery side electrode 21b of the tester side connector 21 is connected to an outer periphery side electrode 22b of the tester side connector 22 at a shield wire short-circuiting part P2.

The core wire short-circuiting part P1 is connected to a terminal 24 through the jig circuit 23. The shield wire short-circuiting part P2 is connected to a terminal 25 through the jig circuit 23. The terminals 24 and 25 of the jig circuit 23 are respectively connected to output electrodes 31 and 32 of an insulation resistance/withstand voltage tester 30.

The insulation resistance/withstand voltage tester 30 has a function for carrying out an insulation resistance test using a DC high voltage and a withstand voltage test using an AC high voltage. Namely, under a state that the DC high voltage (for instance, 1000 V) is applied between the output electrodes 31 and 32, the insulation resistance of the object to be inspected can be measured. Further, under a state that a high voltage (for instance, 1000 V) of a low frequency alternating current (for instance, 50 Hz) is applied between the output electrodes 31 and 32, whether or not an electric breakdown is generated in the object to be inspected can be identified.

Fig. 2 is an equivalent circuit of main parts of the electric circuit shown in Fig. 1. The jig circuit 23 of the jig for the high voltage test 20 includes, as shown in Fig. 2, a time constant circuit 23a and a surge removing circuit 23b.

The time constant circuit 23a is provided to moderate a leading edge and a trailing edge of a wave form when an on/off of the DC voltage outputted by the insulation resistance/withstand voltage tester 30 are switched. In a structural example shown in Fig. 2, two resistors and three capacitors are provided, however, the time constant circuit 23a may be formed only by one resistor and one capacitor.

The surge removing circuit 23b is provided to protect an entire part of a system. Namely, the surge removing circuit 23b removes a surge voltage so that parts of the circuit are not respectively destroyed when an abnormally high voltage (the surge voltage) is temporarily applied due to any cause. In this structural example, the surge removing circuit 23b is formed with two diodes connected in series with polarities in reversed direction to each other. Since the surge removing circuit 23b is prepared for protection for the worst, the surge removing circuit may be omitted.

Fig. 4 shows supposed connection states of main circuit elements of the parts which give an influence to the wire harness 10 for the antenna when a voltage for a test is applied to the wire harness 10 for the antenna shown in Fig. 1 and Fig. 3. Substances of the circuit elements shown in Fig. 4 are respectively described blow.

C1: an electrostatic capacity corresponding to the capacitor 14 in the harness side connector 12
R: the insulation resistance between the core wire 11a and the shield conductor 11b
C2: a floating capacity between the core wire 11a and the shield conductor 11b L: an inductor component existing in the core wire 11a

Accordingly, the equivalent circuit of the wire harness 10 for the antenna includes the components C1, C2 and L respectively as shown in Fig. 2.

As shown in Fig. 1, the central electrode 21a of the tester side connector 21 and the central electrode 22a of the tester side connector 22 are short-circuited at the core wire short-circuiting part P1, so that the one end and the other end of the capacitor 14 are electrically connected to each other. Accordingly, in a steady state, a voltage between both the ends of the capacitor 14 is 0 V. However, even when the DC voltage is applied from the output of the insulation resistance/withstand voltage tester 30 is applied at the time of the test, a rise and a fall of the high voltage are generated during a switch of on/off. Thus, there is a possibility that influences of the components C1, C2 and L respectively shown in Fig. 2 may appear in an AC component at that time and the high voltage may appear between both the ends of the capacitor 14. Particularly, when a length of the coaxial cable 11 is large, there is a possibility that the influences of the components C1, C2 and L may be respectively increased.

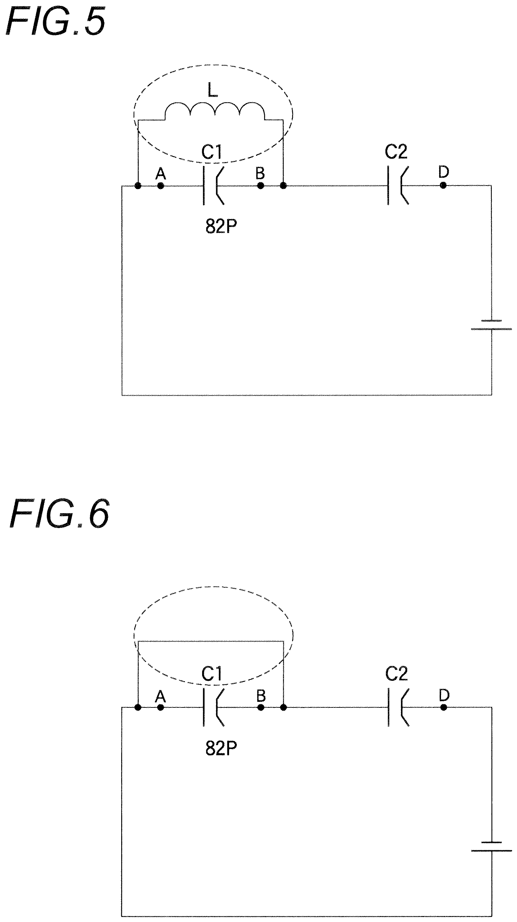

The equivalent circuit of the wire harness 10 for the antenna immediately after the DC voltage for the test is applied is represented as shown in Fig. 5. Namely, immediately after the DC voltage is applied, a counter electromotive force is generated for a short period (for instance, 8ns) by the inductor component L. Thus, a voltage Vc1 expressed by a below-described equation appears at both the ends of the capacitor 14 due to this influence.

$$Vc1 = (\text{applied voltage}) \times C2/(C1 + C2) \quad .....(1)$$

Further, the equivalent circuit of the wire harness 10 for the antenna after the DC voltage for the test is applied, and then, a sufficient time elapses is represented as shown in Fig. 6. Namely, when the sufficient time elapses after the DC voltage is applied, since the influence of the counter electromotive force of the inductor component L is eliminated, both the ends of the capacitor (C1) are short-circuited at the core wire short-circuiting part P1. Thus, both the ends of the capacitor 14 (C1) have the same electric potential.

Namely, even when one end and the other end of the wire harness 10 for the antenna are short-circuited at the core wire short-circuiting part P1 by using the jig for the high voltage test 20, the voltage expressed by the above-described equation (1) is temporarily applied to the capacitor 14. When a level of the voltage exceeds a withstand voltage (for instance, 50 V) of the capacitor 14, the capacitor 14 may be possibly broken down.

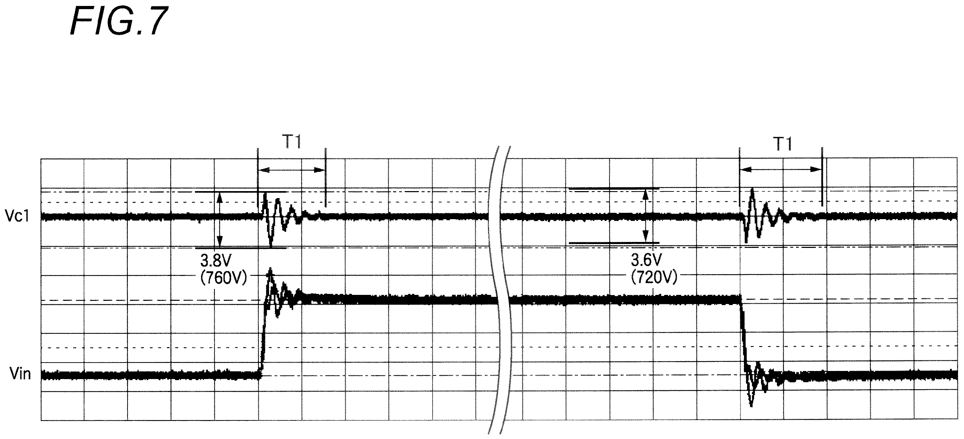

Fig. 7 shows a wave form of the voltage when the time constant circuit 23a is not provided in the jig for the high voltage test 20. Namely, when an input voltage Vin (a voltage between a point A and a point D) applied to the wire harness 10 for the antenna suddenly changes like the wave form shown in Fig. 7, the voltage Vc1 appears at both the ends of the capacitor 14 (C1)during a period T1 of a transient state. In an example shown in Fig. 7, when a change of 5 V is applied as the input voltage Vin, the voltage Vc1 of an amplitude of 3.8 V at the maximum is observed. Accordingly, if 1000 V is applied as the input voltage Vin, the high voltage of 760 V is applied to both the ends of the capacitor 14 (C1) to electrically break down the capacitor 14.

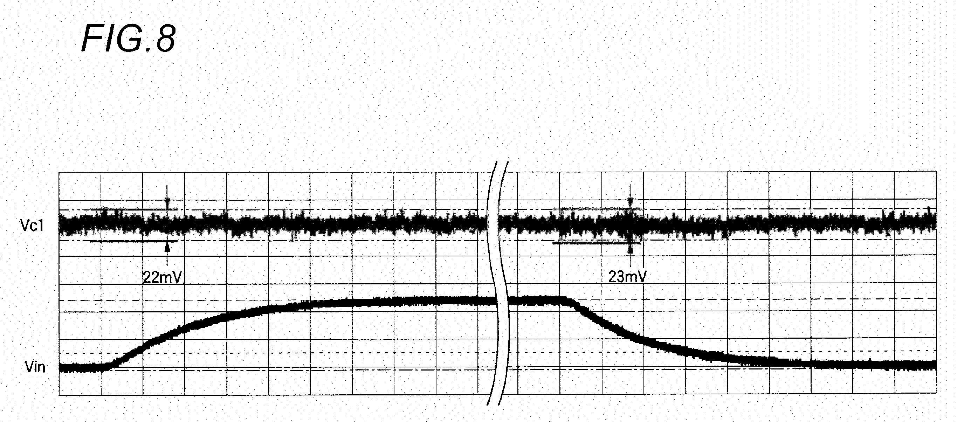

On the other hand, Fig. 8 shows a wave form of the voltage when the time constant circuit 23a is provided in the jig for the high voltage test 20. Namely, the input voltage Vin (the voltage between the point A and the point D) applied to the wire harness 10 for the antenna has a wave form the rise and fall of which are gentle like the wave form shown in Fig. 8 due to an influence of the time constant circuit 23a.

As a result, even during a period of a transient state, the voltage Vc1 appearing at both the ends of the capacitor 14 (C1) is lowered to a level as low as noise.

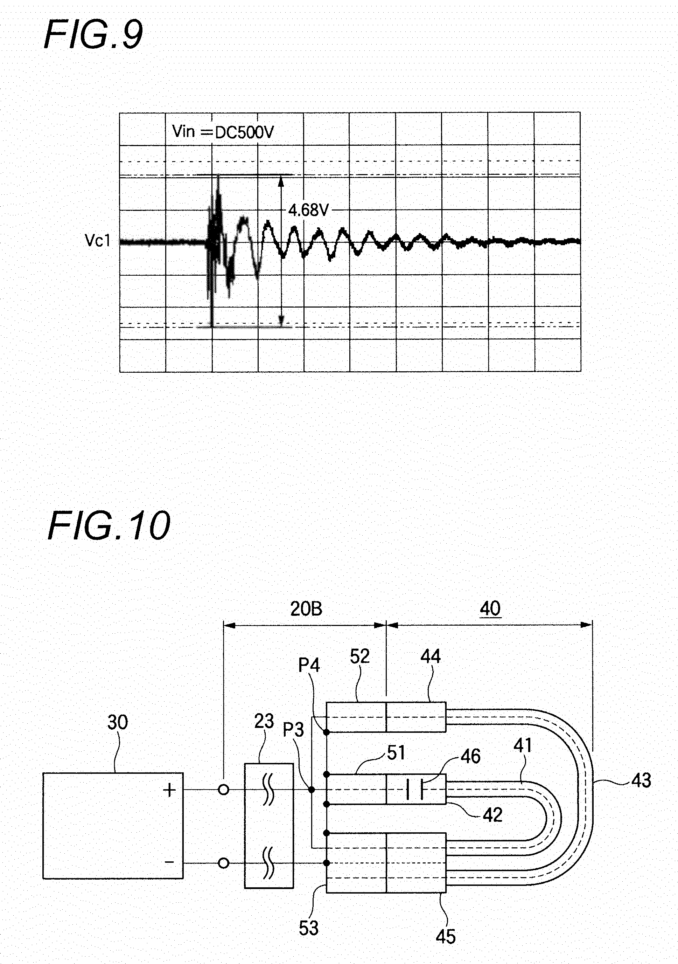

In Fig. 9, an example of a waveform of a voltage is shown which appears between terminals of the capacitor 14 (C1) in the wire harness 10 for the antenna in an actual test state. In the example shown in Fig. 9, the voltage Vc1 is shown which appears at both the ends of the capacitor 14 (C1) in a transient state when DC 500 V is applied as the input voltage Vin. In this example, a maximum value of amplitude of the voltage Vc1 is 4.68 V. Thus, when the ordinary withstand voltage (for instance 50 V) of the capacitor 14 is considered, a problem does not arise.

Specifically, at the time of the insulation resistance test of the wire harness 10 for the antenna, even when the DC high voltage (for instance, 1000 V) outputted by the insulation resistance/withstand voltage tester 30 is abruptly switched on and off, if the time constant circuit 23a is mounted on the jig for the high voltage test 20, the high voltage exceeding the withstand voltage can be prevented from being applied between the terminals of the capacitor 14 in the transient state. When a change of the voltage outputted from the insulation resistance/withstand voltage tester 30 is gentle, or when the influence of the inductor component L is low as in the case of the coaxial cable 11 having a relatively small length, there is a possibility that even when the time contact circuit 23a is not provided, a problem does not arise.

(Modified Example)

Fig. 10 shows a connection state when a wire harness 40 for an antenna is tested by using a high voltage testing device of a modified example. In an example shown in Fig. 10, the wire harness 40 for the antenna used as an object to be inspected includes two coaxial cables 41 and 43 and harness side connectors 42, 44 and 45. Namely, one end of the coaxial cable 41 and one end of the coaxial cable 43 are connected to the common harness side connector 45. The other end of the coaxial cable 41 is connected to the harness side connector 42 and the other end of the coaxial cable 43 is connected to the harness side connector 44.

The harness side connector 42 is a JASO plug. The harness side connector 45 is a high frequency connector (HFC). The harness side connector 44 is a JASO mini-plug. In the harness side connector 42, a capacitor 46 is built.

A jig for a high voltage test (a high voltage testing device) 20B shown in Fig 10 is formed so that an entire part of the wire harness 40 for the antenna may be inspected only by a test of one time. Namely, the jig for the high voltage test 20B has tester side connectors 51, 52 and 53. Further, the tester side connector 51, the tester side connector 52 and the tester side connector 53 are arranged at mutually close positions. As shown in Fig. 10, the tester side connector 51 is connected to the harness side connector 42. The tester side connector 52 is connected to the harness side connector 44. The tester side connector 53 is connected to the harness side connector 45.

Further, at a core wire short-circuiting part P3, a central electrode of the tester side connector 51, a central electrode of the tester side connector 52 and a central electrode of the tester side connector 53 are electrically and commonly connected. Further, at a shield wire short-circuiting part P4, an outer periphery side electrode of the tester side connector 51, an outer periphery side electrode of the tester side connector 52 and an outer periphery side electrode of the tester side connector 53 are electrically and commonly connected.

Accordingly, under a connected state as shown in Fig. 10, when a voltage is outputted from an output of an insulation resistance/withstand voltage tester 30, the voltage can be applied to an entire part of the coaxial cable 41 and an entire part of the coaxial cable 43. Thus, a test of the whole part of the wire harness 40 for the antenna can be completed only by an operation of a time.

As described above, the high voltage testing device of the present invention can be used when an insulation resistance test or a withstand voltage test of, for instance, an antenna cable mounted on a vehicle is carried out. Especially, even when the cable as an object to be inspected has the capacitor built therein, the entire part of the cable can be completely tested only by the operation of one time, which contributes to an improvement of a working property. Further, since the test can be started only by connecting the connectors, an excessively high voltage can be prevented from being applied to the capacitor by a wrong connecting operation. Further, since the time constant circuit is mounted, an excessively high voltage can be prevented from being applied to the capacitor in a temporary transient state.

The present invention is described in detail by referring to the specific exemplary embodiment, however, it is to be understood to a person with ordinary skill in the art that various changes or modifications may be added without deviating from the spirit and scope of the present invention.

According to the present invention, even when the coaxial cable in which the capacitor is built is tested, the entire part of the cable can be tested by a simple operation without breaking down the capacitor.

Description of Reference Numerals and Signs

10....wire harness for antenna
11...coaxial cable
11a....core wire
11b...shield conductor
12, 13....harness side connector
14....capacitor
20, 20B...jig for high voltage test (high voltage testing device)
21, 22... tester side connector
23...jig circuit
23a...time constant circuit
23b...surge removing circuit
24, 25...terminal
30...insulation resistance/withstand voltage tester
31, 32...output electrode

40...wire harness for antenna

41, 43...coaxial cable

42, 44, 45...harness side connector

46... capacitor

51, 52. 53... tester side connector

P1, P3....core wire short-circuiting part

P2, P4...shield wire short-circuiting part

X...radio unit

Y...antenna amplifier

**Claims**

1.  A high voltage testing device for inspecting a coaxial cable (11), the coaxial cable (11) including a core wire (11a) and a shield conductor (11b) arranged so as to surround a periphery of the core wire (11a) with an insulating material sandwiched between the core wire (11a) and the shield conductor (11b), wherein the voltage testing device is adapted to apply a high voltage between the core wire (11a) and the shield conductor (11b) of the coaxial cable (11) to carry out a test of an electric insulation state, the high voltage testing device comprising:
    a cable connecting part (21, 22; 51 - 52) for respectively connecting two electrodes of an output of a tester (30) adapted to output a high voltage to the core wire (11a) and the shield conductor (11b) of the coaxial cable (11); wherein the cable connecting part (20) includes:

    a core wire (11a) short-circuiting part (P1; P3) for electrically short-circuiting between one end and the other end in the longitudinal direction of the core wire (11a) of the coaxial cable (11); and
    a shield wire short-circuiting part (P2; P4) for electrically short-circuiting between one end and the other end in the longitudinal direction of the shield conductor (11b) of the coaxial cable (11).

2.  The high voltage testing device according to claim 1, further comprising:
    a time constant circuit (23a) for moderating a leading edge and a trailing edge of a wave form of the output of the tester (30), wherein the time constant circuit (23a) is connected between the output of the tester (30) and an input of the cable connecting part (21, 22; 51 - 52) and comprises a resistor and a capacitor.

3.  The high voltage testing device according to claim 2, wherein the time constant circuit (23a) has a surge removing circuit (23b) for absorbing an abnormal high voltage.

4.  The high voltage testing device according to claim 1, wherein the cable connecting part (21, 22; 51 - 52) includes two or more coaxial connectors (21, 22; 51 - 52) which are respectively to be connected to the connectors (12, 13; 42 - 45) provided in one end side and the other end side in the longitudinal direction of the coaxial cable (11).

5.  The high voltage testing device according to any of claims 1 to 4, wherein the high voltage is about 1000 V.

6.  A high voltage testing method for inspecting, a coaxial cable (11) including a core wire (11a) and a shield conductor (11b) arranged so as to surround a periphery of the core wire (11a) with an insulating material sandwiched between the core wire (11a) and the shield conductor (11b);
    connecting two electrodes of an output of a tester (30) adapted to output a high voltage to the core wire (11a) and the shield conductor (11b) of the coaxial cable (11), respectively;
    electrically short-circuiting between one end and the other end in the longitudinal direction of the core wire (11a) of the coaxial cable (11);
    electrically short-circuiting between one end and the other end in the longitudinal direction of the shield conductor (11b) of the coaxial cable (11); and
    applying a high voltage between the core wire (11a) and the shield conductor (11b) of the coaxial cable (11) to carry out a test of an electric insulation state.

7.  The high voltage testing method according to claim 6, further comprising:
    a step of moderating a leading edge and a trailing edge of a wave form of the output of the tester (30).

8.  The high voltage testing method according to claim 7, further comprising:
    a step of absorbing an abnormal high voltage.

**9.** The high voltage testing method according to any of claims 6 to 8, wherein the high voltage is about 1000V.

**Patentansprüche**

**1.** Hochspannungstestvorrichtung zur Inspektion eines Koaxialkabels (11), wobei das Koaxialkabel (11) eine Kernleitung (11a) und einen Schirmleiter (11d) aufweist, der so angeordnet ist, dass er einen Umfang der Kernleitung (11a) umgibt, wobei ein isolierendes Material zwischen der Kernleitung (11a) und dem Schirmleiter (11b) eingeschlossen ist, wobei die Spannungstestvorrichtung ausgebildet ist, eine Hochspannung zwischen der Kernleitung (11a) und dem Schirmleiter (11b) des Koaxialkabels (11) anzulegen, um eine Prüfung eines elektrischen Isolationszustand auszuführen, wobei die Hochspannungstestvorrichtung umfasst:
ein Kabelanschlussteil (21, 22; 51 - 52) zum entsprechenden Anschluss zweier Elektroden eines Ausgangs einer Prüfeinheit (30), die ausgebildet ist, eine Hochspannung an die Kernleitung (11a) und den Schirmleiter (11b) des Koaxialkabels (11) auszugeben, wobei das Kabelanschlussteil (21, 22; 51 - 52) beinhaltet:

ein Kernleitungs-(11a) Kurzschlussteil (P1; P3) zur Erzeugung eines elektrischen Kurzschlusses zwischen einem Ende und dem anderen Ende in der Längsrichtung der Kernleitung (11a) des Koaxialkabels (11); und
ein Schirmleitungs-Kurzschlussteil (P2; P4) zur Zeugung eines elektrischen Kurzschlusses zwischen einem Ende und dem anderen Ende in der Längsrichtung des Schirmleiters (11b) des Koaxialkabels (11).

**2.** Hochspannungstestvorrichtung nach Anspruch 1, ferner mit:
einer Zeitkonstanten-Schaltung (23a) zum Moderieren einer vorderen Flanke und einer hinteren Flanke einer Signalform des Ausgangs der Prüfeinheit (30), wobei die Zeitkonstanten-Schaltung (23a) zwischen dem Ausgang der Prüfeinheit (30) und einem Eingang des Kabelanschlussteils (21, 22; 51 - 52) angeschlossen ist und einen Widerstand und einen Kondensator aufweist.

**3.** Hochspannungstestvorrichtung nach Anspruch 2, wobei die Zeitkonstanten-Schaltung (23a) eine Spannungsspitzenentfernungsschaltung (23b) zur Absorption einer von der Norm abweichenden hohen Spannung hat.

**4.** Hochspannungstestvorrichtung nach Anspruch 1, wobei das Kabelanschlussteil (21, 22; 51 - 52) zwei oder mehr koaxiale Verbindungseinrichtungen (21, 22; 51 - 52) aufweist, die entsprechend mit den Verbindungseinrichtungen (12, 13; 42 - 45) verbunden sind, die auf Seite des einen Endes und auf Seite des anderen Endes in der Längsrichtung des Koaxialkabels (11) vorgesehen sind.

**5.** Hochspannungstestvorrichtung nach einem der Ansprüche 1 bis 4, wobei die Hochspannung ungefähr 1000 V beträgt.

**6.** Hochspannungstestverfahren zur Inspektion eines Koaxialkabels (11), das eine Kernleitung (11a) und einen Schirmleiter (11b) aufweist, der so angeordnet ist, dass er einen Umfang der Kernleitung (11a) umgibt, wobei ein isolierendes Material zwischen der Kernleitung (11a) und dem Schirmleiter (11b) eingeschlossen ist;
Anschließen zweier Elektroden eines Ausgangs einer Prüfeinheit (30), die zur Ausgabe einer Hochspannung an die Kernleitung (11a) und den Schirmleiter (11b) des Koaxialkabels (11) ausgebildet ist;
Erzeugen eines elektrischen Kurzschlusses zwischen einem Ende und dem anderen Ende in der Längsrichtung der Kernleitung (11a) des Koaxialkabels (11);
Erzeugen eines elektrischen Kurzschlusses zwischen einem Ende und dem anderen Ende in der Längsrichtung des Schirmleiters (11b) des Koaxialkabels (11); und
Anlegen einer Hochspannung zwischen der Kernleitung (11a) und dem Schirmleiter (11b) des Koaxialkabels (11), um eine Prüfung eines elektrischen Isolationszustands auszuführen.

**7.** Hochspannungstestverfahren nach Anspruch 6, ferner mit:
einem Schritt zum Moderieren einer vorderen Flanke und einer hinteren Flanke eine Signalform des Ausgangs der Prüfeinheit (30).

**8.** Hochspannungstestverfahren nach Anspruch 7, ferner mit:
einem Schritt zum Absorbieren einer von der Norm abweichenden hohen Spannung.

**9.** Hochspannungstestverfahren nach einem der Ansprüche 6 bis 8, wobei die Hochspannung ungefähr 1000 V beträgt.

**Revendications**

1. Dispositif de test de haute tension pour inspecter un câble coaxial (11), le câble coaxial (11) comprenant un fil central (11a) et un conducteur de blindage (11b) agencé de manière à entourer la périphérie du fil central (11a) avec un matériau isolant intercalé entre le fil central (11a) et le conducteur de blindage (11b), dans lequel le dispositif de test de tension est adapté pour appliquer une haute tension entre le fil central (11a) et le conducteur de blindage (11b) du câble coaxial (11) pour mettre en oeuvre un test d'état d'isolation électrique, le dispositif de test de haute tension comprenant :

   une partie de connexion de câble (21, 22 ; 51 - 52) pour connecter respectivement deux électrodes de sortie d'un appareil de test (30) adapté pour sortir une haute tension sur le fil central (11a) et le conducteur de blindage (11b) du câble coaxial (11) ;
   dans lequel la partie de connexion de câble (20) comprend :

      une partie de court-circuitage (P1 ; P3) du fil central (11a) pour établir un court-circuit électrique entre une extrémité et l'autre extrémité en direction longitudinale du fil central (11a) du câble coaxial (11) ; et
      une partie de court-circuitage (P2 ; P4) du fil de blindage pour établir un court-circuit électrique entre une extrémité et l'autre extrémité en direction longitudinale du conducteur de blindage (11b) du câble coaxial (11).

2. Dispositif de test de haute tension selon la revendication 1, comprenant en outre :
   un circuit de constante de temps (23a) pour modérer le flanc avant et le flanc arrière d'une forme d'onde de la sortie de l'appareil de test (30), dans lequel le circuit de constante de temps (23a) est connecté entre la sortie de l'appareil de test (30) et une entrée de la partie de connexion de câble (21, 22 ; 51 - 52) et comprend une résistance et un condensateur.

3. Dispositif de test de haute tension selon la revendication 2, dans lequel le circuit de constante de temps (23a) comporte un circuit d'élimination de surtension (23b) pour absorber une haute tension anormale.

4. Dispositif de test de haute tension selon la revendication 1, dans lequel la partie de connexion de câble (21, 22 ; 51 - 52) comprend deux ou plusieurs connecteurs coaxiaux (21, 22 ; 51 - 52) qui sont destinés à être connectés respectivement aux connecteurs (12, 13 ; 42 - 45) pourvus à un côté d'extrémité et à l'autre côté d'extrémité en direction longitudinale du câble coaxial (11).

5. Dispositif de test de haute tension selon l'une quelconque des revendications 1 à 4, dans lequel la haute tension est d'environ 1000 V.

6. Procédé de test de haute tension pour
   l'inspection d'un câble coaxial (11) comprenant un fil central (11a) et un conducteur de blindage (11b) agencé de manière à entourer la périphérie du fil central (11a) avec un matériau isolant intercalé entre le fil central (11a) et le conducteur de blindage (11b) ;
   la connexion de deux électrodes d'une sortie d'un appareil de test (30) adapté pour sortir une haute tension sur respectivement le fil central (11a) et le conducteur de blindage (11b) du câble coaxial (11) ;
   le court-circuitage électrique entre une extrémité et l'autre extrémité en direction longitudinale du fil central (11a) du câble coaxial (11) ;
   le court-circuitage électrique entre une extrémité et l'autre extrémité en direction longitudinale du conducteur de blindage (11b) du câble coaxial (11) ; et
   l'application d'une haute tension entre le fil central (11a) et le conducteur de blindage (11b) du câble coaxial (11) pour mettre en oeuvre un test d'un état d'isolation électrique.

7. Procédé de test de haute tension selon la revendication 6, comprenant en outre :
   une étape de modération d'un flanc avant et d'un flanc arrière d'une forme d'onde de la sortie de l'appareil de test (30).

8. Procédé de test de haute tension selon la revendication 7, comprenant en outre :
   une étape d'absorption d'une haute tension anormale.

9. Procédé de test de haute tension selon l'une quelconque des revendications 6 à 8, dans lequel la haute tension est d'environ 1000 V.

## FIG.1

## FIG.2

## FIG.3

## FIG.4

## FIG.5

## FIG.6

## FIG.7

EP 2 642 306 B1

FIG.8

EP 2 642 306 B1

# FIG.9

# FIG.10

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001202836 A
- JP 2005265684 A
- JP H01191073 A